# DEMANDE DE BREVET EUROPEEN

(11) **EP 3 961 689 A1**
(43) Date de publication de la demande: **02.03.2022**
(21) Numéro de dépôt: 21193198.5
(22) Date de dépôt: 26.08.2021
(51) Int. Cl.: H01L 21/8234, H01L 29/66, H01L 21/28, H01L 21/8238

(54) **PROCÉDÉ DE FABRICATION DE COMPOSANTS MICROÉLECTRONIQUES**

(30) Priorité: 31.08.2020 FR 2008840
(71) Demandeur: Commissariat à l'Energie Atomique et aux Energies Alternatives, 75015 Paris (FR)
(72) Inventeur: NEMOUCHI, Fabrice, 38054 GRENOBLE Cedex 09 (FR); FITZ, Clemens, 01468 MORITZBURG (DE); POSSEME, Nicolas, 38054 GRENOBLE Cedex 09 (FR)
(74) Mandataire: Decobert, Jean-Pascal

(57) **Abrégé**

L'invention concerne un procédé de réalisation d'une pluralité de transistors sur un substrat comprenant au moins deux zones actives (20) adjacentes séparées par au moins une zone d'isolation électrique (30), chaque transistor de la pluralité de transistors comprenant une grille (10) présentant une portion siliciurée (12), et des premiers et deuxièmes espaceurs (11a, 11b) de part et d'autre de la grille (10), les premiers espaceurs (11a) étant situés sur des flancs de la grille (10a) et les deuxièmes espaceurs (11b) étant situés sur des flancs des premiers espaceurs (11a), le procédé comprenant les étapes suivantes :
- une formation des grilles des transistors,
- une formation des premiers espaceurs (11a),
- une formation des deuxièmes espaceurs (11b),
- une siliciuration des grilles configurée pour former les portions siliciurées (12) des grilles,
- un retrait des deuxièmes espaceurs (11b),
le retrait (SPT) des deuxièmes espaceurs se faisant pendant la siliciuration des grilles et avant que les portions siliciurées (12) soient totalement formées.

## Description

### DOMAINE TECHNIQUE

La présente invention concerne le domaine de la fabrication de composants micro-électroniques. Elle trouvera pour application avantageuse mais non limitative la fabrication de transistors CMOS (transistors Complémentaires de type Métal Oxyde Semiconducteur).

### ETAT DE LA TECHNIQUE

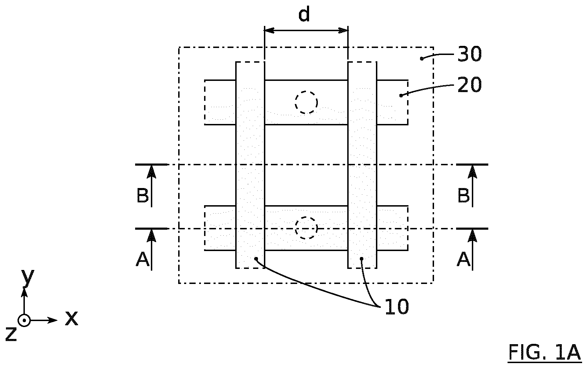

Un schéma d'implantation classique de transistors dans un circuit CMOS est illustré à la figure 1A. Les grilles 10 des transistors s'étendent typiquement de façon transverse sur plusieurs zones actives 20. Pour séparer électriquement les différentes zones actives 10, par exemple de type p et de type n, des tranchées d'isolation peu profondes STI 30 (shallow trench isolation) sont généralement formées.

Pour augmenter globalement les performances d'un circuit CMOS, l'intégration des transistors se fait selon un schéma d'implantation de plus en plus dense. La distance d entre deux grilles 10 adjacentes est ainsi réduite au maximum. Pour augmenter individuellement les performances des transistors, des couches de compression ou de tension également appelées « stress liner » (par exemple CESL pour « Contact Etch Stop Liner» ou DSL pour « Dual Stress Liner») peuvent être déposées sur les grilles 10 des transistors.

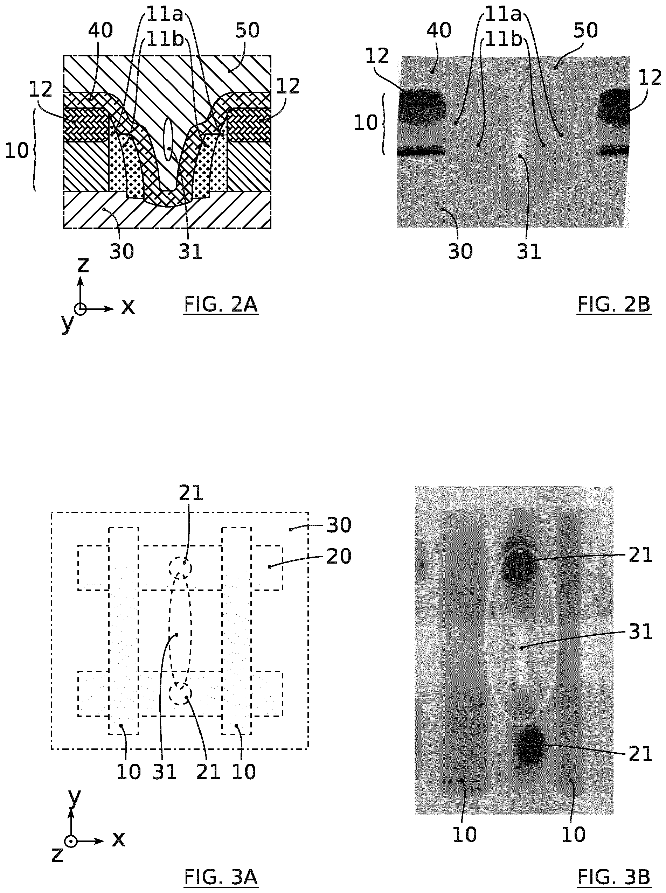

Les figures 2A et 2B sont respectivement un schéma et une image de microscopie électronique à transmission (TEM) de deux grilles 10 adjacentes, vues en coupe selon un plan xz. Le plan de coupe est du type BB comme illustré à la figure 1A et passe au travers de la tranchée d'isolation 30. Sur ces figures 2A, 2B, les grilles 10 de transistors comprennent des portions 12 siliciurées, et sont flanquées par des premiers espaceurs 11a et des deuxièmes espaceurs 11b. Une couche « stress liner» 40 vient recouvrir de façon plus ou moins conforme les grilles 10 et les espaceurs 11a, 11b. Idéalement, une couche de remplissage 50 en un matériau diélectrique, dénommée ILD (acronyme de Inter Layer Dielectric), recouvre le «stress liner» 40 et remplit les espaces entre les flancs de deux grilles 10 adjacentes.

Lorsque la distance d entre deux grilles est faible et/ou l'épaisseur du « stress liner» 40 est importante, le facteur de forme hauteur/largeur des espaces à remplir augmente. Les espaces deviennent difficiles à remplir totalement. Cela conduit à la formation de cavités 31 « fermées », ou vides résiduels, ou encore « voids » selon la terminologie anglo-saxonne couramment utilisée, tel qu'illustré aux figures 2A, 2B.

Ces voids 31 s'étendent le long des grilles 10, d'une zone active 20 à l'autre, comme illustré schématiquement à la figure 3A, et imagé à la figure 3B. Ils peuvent avoir des conséquences néfastes pour les circuits CMOS. Lors de la formation ultérieure des contacts électriques au niveau des portions siliciurées, et en particulier lorsqu'un problème d'alignement de ces contacts électriques survient, les voids peuvent être ouverts et remplis de métal.

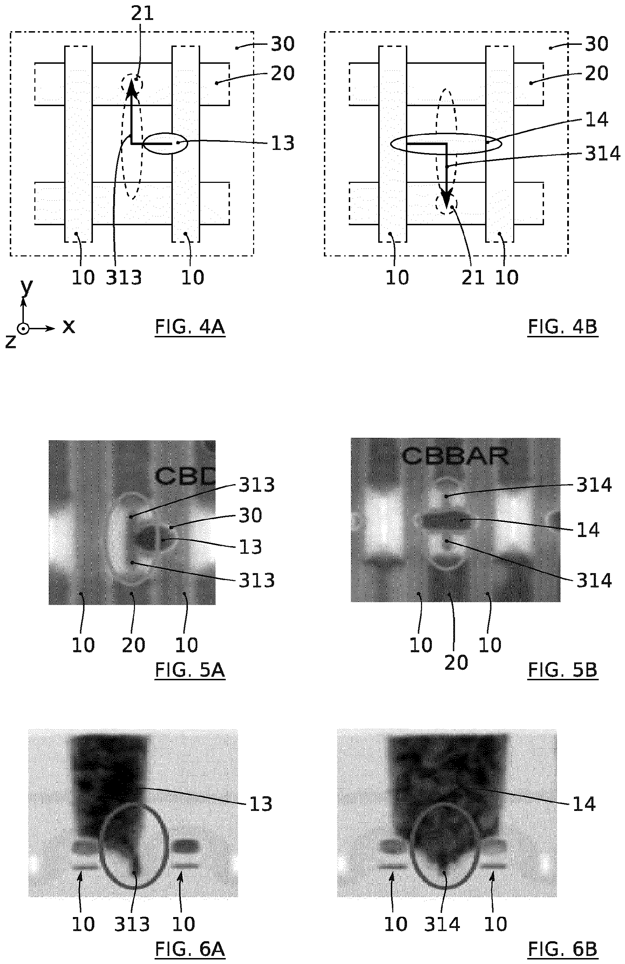

Deux zones actives 20 adjacentes normalement isolées électriquement entre elles par le STI 30, sont dès lors court-circuitées par une connexion électrique via ces voids 31 métallisés. Les figures 4A, 4B illustrent schématiquement deux situations de court-circuit entre différents types de contacts 21, 13, 14.

La figure 4A représente un contact ponctuel de grille 13 désaligné selon x en direction du void 31. Le métal de ce contact 13 peut remplir directement ou indirectement une partie du void 31 et former un court-circuit 313 avec le contact 21.

La figure 4B représente un contact allongé de grille 14 à cheval sur deux grilles 10 adjacentes. Le métal de ce contact 14 peut remplir directement ou indirectement une partie du void 31 et former un court-circuit 314 avec le contact 21.

Les figures 5A et 6A sont respectivement des vues de dessus et en coupe acquises par microscopie électronique de la situation illustrée à la figure 4A. Les figures 5B et 6B sont respectivement des vues de dessus et en coupe acquises par microscopie électronique de la situation illustrée à la figure 4B.

Au regard de ces inconvénients, il est actuellement nécessaire de préserver un espace important entre deux grilles adjacentes. Une solution consiste à introduire une étape de gravure des espaceurs 11b mentionnés plus haut. Cela permet d'accroître la largeur des espaces entre les grilles. Cette solution engendre néanmoins d'autres inconvénients, notamment en affectant les autres portions des transistors, en particulier la portion siliciurée, le matériau semi-conducteur des zones actives ou les STI.

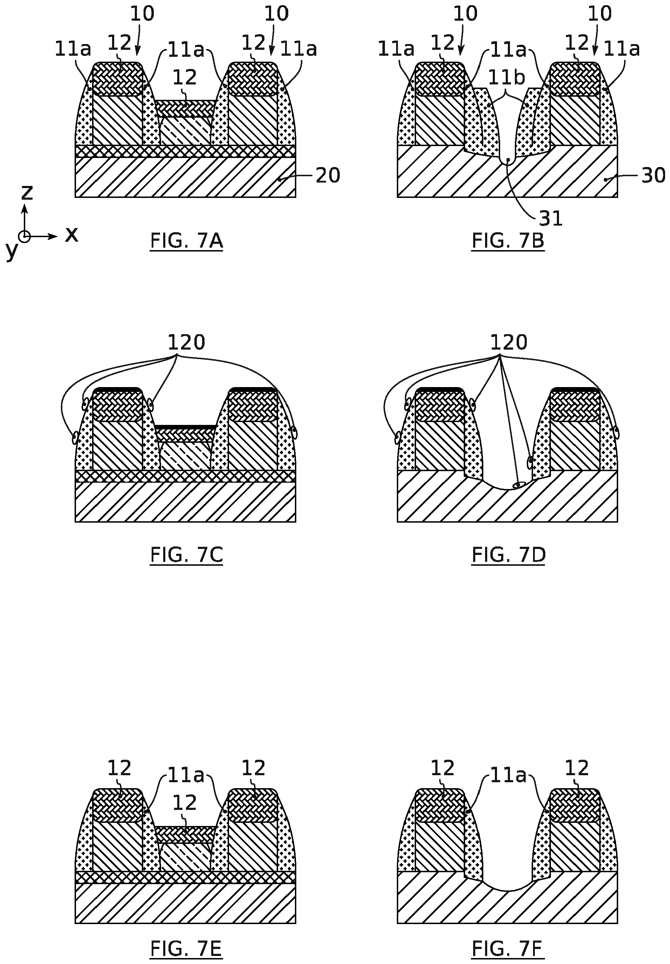

Les figures 7A à 7F illustrent les étapes classiques de retrait des espaceurs 11b, après siliciuration des grilles. La siliciuration des grilles permet de former les portions 12 siliciurées, c'est-à-dire à base de siliciure de Nickel NiSi, sur lesquelles sont formés ultérieurement les contacts 21, 13, 14 (figure 7A). Les espaceurs 11b ont été formés préalablement au niveau des STI 30 (figure 7B). Lors de la formation des espaceurs 11b, les STI 30 peuvent être partiellement endommagés, comme illustré à la figure 7B. Cela peut conduire à la formation de cavités 31 « ouvertes », c'est-à-dire qui communiquent avec le milieu environnant. Ces cavités 31 ouvertes évoluent au cours des étapes ultérieures de fabrication des transistors et peuvent également contribuer à l'apparition des voids 31 fermés vus précédemment, c'est-à-dire sous forme de volume vide au sein d'un matériau plein.

Le retrait des espaceurs 11b se fait typiquement par une gravure isotrope (figure 7D). Les cavités 31 sont agrandies. Des résidus métalliques 120 indésirables sont redéposés à l'issue de cette étape, tel qu'illustré aux figures 7C, 7D. Une étape de nettoyage, par exemple par voie humide avec une solution à base d'acide nitrique, doit dès lors être effectuée pour retirer ces résidus métalliques 120 (figures 7E, 7F). Cela peut encore endommager les STI 30. Cela peut en outre consommer ou endommager une partie des portions siliciurées.

Il existe par conséquent un besoin d'améliorer les techniques de fabrication de composants micro-électroniques actuelles.

La présente invention a notamment pour objet un procédé de réalisation de transistors palliant au moins en partie les inconvénients mentionnés ci-dessus.

En particulier, un objet de la présente invention est de proposer un procédé de fabrication de transistors comprenant un retrait des deuxièmes espaceurs et limitant ou supprimant la formation de vides résiduels.

Les autres objets, caractéristiques et avantages de la présente invention apparaîtront à l'examen de la description suivante et des dessins d'accompagnement. Il est entendu que d'autres avantages peuvent être incorporés.

### RESUME

Un aspect de l'invention concerne un procédé de réalisation d'une pluralité de transistors sur un substrat comprenant au moins deux zones actives adjacentes séparées par au moins une zone d'isolation électrique, chaque transistor de la pluralité de transistors comprenant une grille présentant une portion siliciurée, et des premiers espaceurs de part et d'autre de la grille, les premiers espaceurs étant situés sur des flancs de la grille.

Ce procédé comprend les étapes suivantes :
- une formation des grilles des transistors,
- une formation des premiers espaceurs,
- une formation de deuxièmes espaceurs sur des flancs des premiers espaceurs,
- une siliciuration des grilles configurée pour former les portions siliciurées des grilles,
- un retrait des deuxièmes espaceurs.

Avantageusement, le retrait des deuxièmes espaceurs se fait pendant la siliciuration des grilles et avant que les portions siliciurées soient totalement formées.

Ainsi, ce retrait n'affecte pas les portions siliciurées totalement formées. Cela évite ou limite le dépôt de résidus métalliques indésirables. Cela permet avantageusement de s'affranchir de l'étape de nettoyage des résidus métalliques.

La siliciuration de la grille est typiquement effectuée par une série d'étapes regroupées sous la dénomination « module NiSi ». Ce module NiSi peut notamment comprendre les sous-étapes suivantes :
- Au moins un nettoyage préparatoire,
- Un dépôt d'un alliage de nickel-platine NiPt, notamment aux sommets des grilles,
- Un premier recuit thermique de manière à diffuser et à faire réagir une partie du Nickel Ni dudit alliage NiPt au niveau des portions supérieures des grilles,
- Un retrait intermédiaire de l'alliage de nickel-platine NiPt enrichi en Platine Pt à l'issue du premier recuit thermique,
- Un deuxième recuit thermique,
- Un retrait d'une partie résiduelle d'alliage NiPt, de manière à former et/ou exposer les portions siliciurées, c'est-à-dire à base de siliciure de Nickel NiSi.

Le retrait, total ou partiel, des deuxièmes espaceurs se fait dans ce cas avant le retrait de la partie résiduelle d'alliage NiPt, de préférence immédiatement avant le retrait de la partie résiduelle d'alliage NiPt, de préférence avant le deuxième recuit thermique, de préférence avant le dépôt de l'alliage de nickel-platine NiPt, et de préférence avant l'au moins un nettoyage préparatoire.

L'invention concerne aussi des transistors obtenus par les aspects décrits du procédé de l'invention.

Selon un aspect séparable, l'invention concerne également un procédé de réalisation d'une pluralité de transistors sur un substrat comprenant au moins deux zones actives adjacentes séparées par au moins une zone d'isolation électrique, chaque transistor de la pluralité de transistors comprenant une grille présentant une portion siliciurée, et des premiers et deuxièmes espaceurs de part et d'autre de la grille, les premiers espaceurs étant situés sur des flancs de la grille et les deuxièmes espaceurs étant situés sur des flancs des premiers espaceurs.

Ce procédé comprend les étapes suivantes :
- une formation des grilles des transistors,
- une formation des premiers espaceurs,
- une formation des deuxièmes espaceurs,
- une siliciuration des grilles configurée pour former les portions siliciurées des grilles, ladite siliciuration des grilles comprenant les sous-étapes suivantes :
   i. Un dépôt d'un alliage de nickel-platine NiPt aux sommets des grilles,
   ii. Un premier recuit thermique de manière à diffuser et faire réagir une partie du Nickel Ni dudit alliage NiPt au niveau des portions supérieures des grilles,
   iii. Un retrait intermédiaire de l'alliage de nickel-platine NiPt enrichi en Platine Pt,
   iv. Un retrait d'une partie résiduelle d'alliage NiPt n'ayant pas réagi, de manière à former les portions siliciurées,
- un retrait des deuxièmes espaceurs.

Avantageusement, le retrait des deuxièmes espaceurs se fait pendant la siliciuration des grilles avant que les portions siliciurées soient totalement formées, après le retrait intermédiaire, de préférence immédiatement après, et avant le retrait de la partie résiduelle.

### BREVE DESCRIPTION DES FIGURES

Des buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1A illustre schématiquement, en vue de dessus, un substrat comprenant des zones actives et des zones d'isolation électrique adjacentes, sur lesquelles sont disposées des grilles de transistors.
La figure 2A illustre schématiquement, en coupe, deux transistors adjacents et un vide résiduel entre ces transistors.
La figure 2B est une image de microscopie électronique montrant, en coupe, deux transistors adjacents et un vide résiduel entre ces transistors, tel qu'illustré à la figure 2A.
La figure 3A illustre schématiquement, en vue de dessus, deux transistors adjacents et un vide résiduel entre ces transistors.
La figure 3B est une image de microscopie électronique montrant, en vue de dessus, deux transistors adjacents et un vide résiduel entre ces transistors, tel qu'illustré à la figure 3A.
La figure 4A illustre schématiquement, en vue de dessus, une première situation de court-circuit via le vide résiduel illustré à la figure 3A.
La figure 4B illustre schématiquement, en vue de dessus, une deuxième situation de court-circuit via le vide résiduel illustré à la figure 3A.
La figure 5A est une image de microscopie électronique montrant, en vue de dessus, une première situation de court-circuit, telle qu'illustrée à la figure 4A.
La figure 5B est une image de microscopie électronique montrant, en vue de dessus, une deuxième situation de court-circuit, telle qu'illustrée à la figure 4B.
La figure 6A est une image de microscopie électronique montrant, en coupe, une première situation de court-circuit, telle qu'illustrée à la figure 4A.
La figure 6B est une image de microscopie électronique montrant, en coupe, une deuxième situation de court-circuit, telle qu'illustrée à la figure 4B.
Les figures 7A à 7F illustrent des étapes de retrait des deuxièmes espaceurs, selon l'art antérieur.

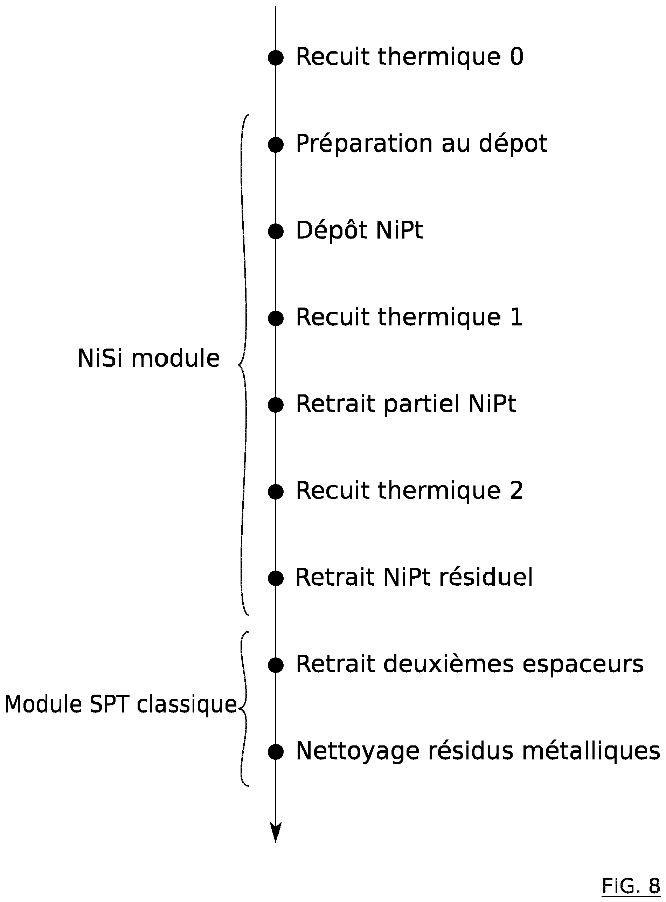

La figure 8 montre sous forme d'organigramme des étapes de siliciuration et de retrait des deuxièmes espaceurs, selon l'art antérieur.

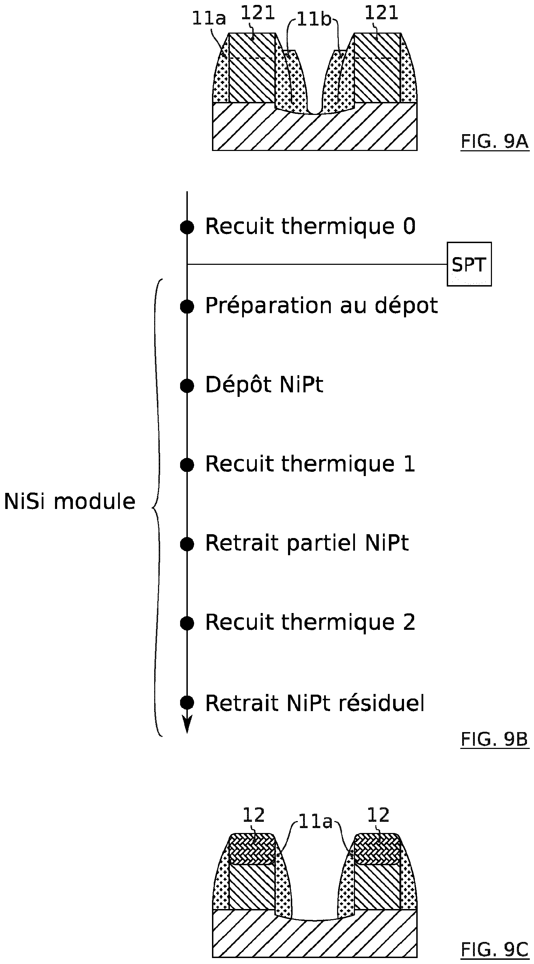

La figure 9A illustre schématiquement en coupe un dispositif comprenant deux grilles adjacentes avant siliciuration des grilles et retrait des deuxièmes espaceurs.
La figure 9B illustre sous forme d'organigramme des étapes de siliciuration et de retrait des deuxièmes espaceurs, selon un mode de réalisation de la présente invention.
La figure 9C illustre schématiquement en coupe un dispositif comprenant deux grilles adjacentes après siliciuration des grilles et retrait des deuxièmes espaceurs, selon un mode de réalisation de la présente invention.

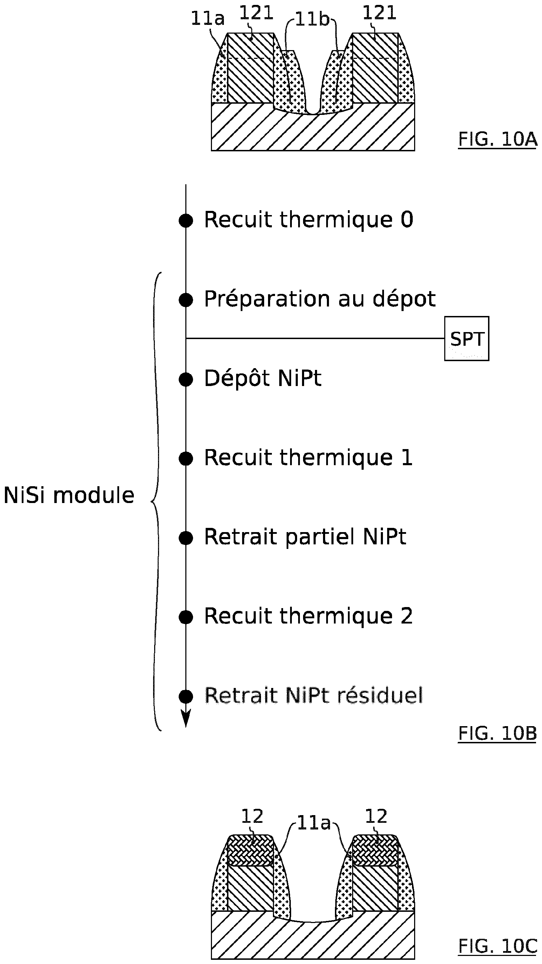

La figure 10A illustre schématiquement en coupe un dispositif comprenant deux grilles adjacentes avant siliciuration des grilles et retrait des deuxièmes espaceurs.
La figure 10B illustre sous forme d'organigramme des étapes de siliciuration et de retrait des deuxièmes espaceurs, selon un mode de réalisation de la présente invention.
La figure 10C illustre schématiquement en coupe un dispositif comprenant deux grilles adjacentes après siliciuration des grilles et retrait des deuxièmes espaceurs, selon un mode de réalisation de la présente invention.

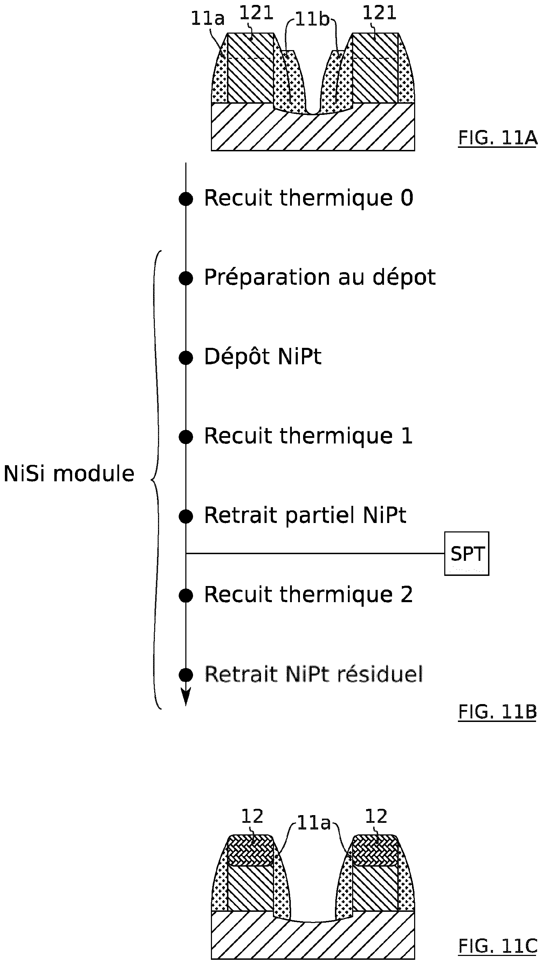

La figure 11A illustre schématiquement en coupe un dispositif comprenant deux grilles adjacentes avant siliciuration des grilles et retrait des deuxièmes espaceurs.
La figure 11B illustre sous forme d'organigramme des étapes de siliciuration et de retrait des deuxièmes espaceurs, selon un mode de réalisation de la présente invention.
La figure 11C illustre schématiquement en coupe un dispositif comprenant deux grilles adjacentes après siliciuration des grilles et retrait des deuxièmes espaceurs, selon un mode de réalisation de la présente invention.

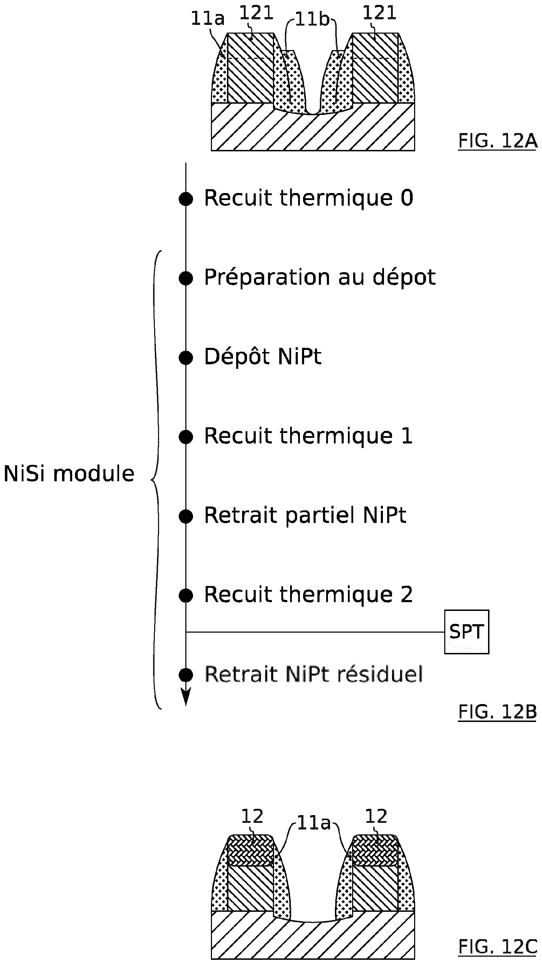

La figure 12A illustre schématiquement en coupe un dispositif comprenant deux grilles adjacentes avant siliciuration des grilles et retrait des deuxièmes espaceurs.
La figure 12B illustre sous forme d'organigramme des étapes de siliciuration et de retrait des deuxièmes espaceurs, selon un mode de réalisation de la présente invention.
La figure 12C illustre schématiquement en coupe un dispositif comprenant deux grilles adjacentes après siliciuration des grilles et retrait des deuxièmes espaceurs, selon un mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différentes couches et portions ne sont pas représentatives de la réalité.

### DESCRIPTION DÉTAILLÉE

Avant d'entamer une revue détaillée de modes de réalisation de l'invention, il est rappelé que l'invention selon son premier aspect comprend notamment les caractéristiques optionnelles ci-après pouvant être utilisées en association ou alternativement.

Selon un exemple, la siliciuration des grilles comprend les sous-étapes suivantes :
- Un dépôt d'un alliage de nickel-platine NiPt aux sommets des grilles,
- Un premier recuit thermique de manière à diffuser et faire réagir une partie du Nickel Ni dudit alliage NiPt au niveau des portions supérieures des grilles,
- Un retrait d'une partie résiduelle d'alliage NiPt de manière à former les portions siliciurées.

Selon un exemple, le retrait des deuxièmes espaceurs se fait avant le retrait de la partie résiduelle. Ainsi, les résidus métalliques générés lors du retrait des deuxièmes espaceurs sont éliminés lors du retrait de la partie résiduelle. Cela permet d'éviter une étape de nettoyage des résidus métalliques postérieure. Cela permet d'économiser une étape de procédé.

Selon un exemple, le retrait des deuxièmes espaceurs se fait avant le dépôt de l'alliage de nickel-platine NiPt aux sommets des grilles. Ainsi, les résidus métalliques générés lors du retrait des deuxièmes espaceurs sont éliminés lors du retrait de la partie résiduelle. Cela permet d'éviter une étape de nettoyage des résidus métalliques postérieure. Cela permet d'économiser une étape de procédé.

Selon un exemple, le procédé comprend en outre, avant le dépôt de l'alliage de nickel-platine NiPt aux sommets des grilles, les sous-étapes suivantes :
- Un recuit thermique préparatoire,
- Au moins un nettoyage préparatoire.

Selon un exemple, le retrait des deuxièmes espaceurs se fait avant l'au moins un nettoyage préparatoire. Cela permet d'éviter de générer des résidus métalliques. Cela permet d'éviter une étape de nettoyage des résidus métalliques postérieure. L'au moins un nettoyage préparatoire permet en outre d'éliminer les résidus organiques générés par le retrait des deuxièmes espaceurs. Si le retrait des deuxièmes espaceurs est effectué par gravure humide isotrope à base d'une solution d'acide fluorhydrique dilué (dHF), l'au moins un nettoyage préparatoire n'est pas nécessaire et peut être supprimé. Cela permet d'économiser au moins une deuxième étape de procédé.

Selon un exemple, le retrait des deuxièmes espaceurs se fait après l'au moins un nettoyage préparatoire et avant le dépôt de l'alliage de nickel-platine NiPt aux sommets des grilles. Cela permet d'éviter de générer des résidus métalliques. Cela permet d'éviter une étape de nettoyage des résidus métalliques postérieure. Si le retrait des deuxièmes espaceurs est effectué par gravure plasma isotrope à partir d'un plasma délocalisé suivi d'un recuit de sublimation, le dépôt de l'alliage de nickel-platine NiPt peut se faire directement sans nécessiter une étape classique de désoxydation de surface préparatoire au dépôt. Cela permet d'économiser une deuxième étape de procédé.

Selon un exemple, le retrait des deuxièmes espaceurs se fait immédiatement avant le retrait de la partie résiduelle.

Selon un exemple, le procédé comprend en outre, après le premier recuit thermique, un retrait intermédiaire de l'alliage de nickel-platine NiPt enrichi en Platine Pt à l'issue du premier recuit thermique. Ce retrait intermédiaire est typiquement suivi d'un deuxième recuit thermique. L'étape de retrait intermédiaire sert essentiellement à retirer un excès de métal, en particulier le métal qui n'a pas réagi aux sommets des grilles - l'alliage NiPt intermédiaire - et/ou sur les STI et/ou sur les espaceurs. A l'issue du retrait intermédiaire, une phase riche en Ni est conservée au sommet des grilles. Le deuxième recuit thermique permet de poursuivre la diffusion du nickel depuis le sommet des grilles de façon à obtenir les portions siliciurées à base de NiSi.

Selon un exemple, le retrait des deuxièmes espaceurs se fait après ledit retrait intermédiaire, et de préférence immédiatement après et de préférence avant le deuxième recuit thermique. La phase riche en Ni est plus robuste que la portion NiSi sous-jacente (en partie siliciurée) vis-à-vis du retrait des deuxièmes espaceurs. La portion en partie siliciurée n'est donc pas endommagée. La génération de résidus métalliques est dès lors limitée. Les résidus métalliques sont en outre éliminés lors du retrait du platine. Cela permet d'éviter une étape de nettoyage des résidus métalliques postérieure. Cela permet d'économiser une étape de procédé.

Selon un exemple, les deuxièmes espaceurs sont formés directement sur les flancs des premiers espaceurs, c'est-à-dire sans couche intermédiaire entre eux.

Selon un exemple, les premiers espaceurs sont à base de SiO2, ou de SiN, ou de Si3N4, ou de SiON, ou de SiOx ou d'un autre matériau diélectrique à base de Si, O, C, N.

Selon un exemple, les deuxièmes espaceurs sont à base de SiO2, ou de SiN, ou de Si3N4, ou de SiON, ou de SiOx ou d'un autre matériau diélectrique à base de Si, O, C, N.

Selon un exemple, les premiers espaceurs sont à base d'un matériau différent de celui des deuxièmes espaceurs.

Selon un exemple, le retrait des deuxièmes espaceurs se fait par une gravure plasma isotrope.

Selon un exemple, la gravure plasma isotrope est à base d'espèces fluorocarbonées. Cela permet de graver rapidement des espaceurs à base de nitrure tout en présentant une bonne sélectivité vis-à-vis de l'oxyde de silicium des tranchées d'isolation STI.

Selon un exemple, la gravure plasma isotrope est effectuée à partir d'un plasma délocalisé suivi d'un recuit de sublimation. Une telle gravure peut être un procédé de type SiCoNi^{®}.

Selon un exemple, le retrait des deuxièmes espaceurs se fait par une gravure humide isotrope.

Selon un exemple, la gravure humide isotrope est à base d'une solution d'acide fluorhydrique dilué (dHF) et d'acide phosphorique chaud. Cela permet de graver rapidement des espaceurs à base de nitrure tout en présentant une bonne sélectivité vis-à-vis de l'oxyde de silicium des tranchées d'isolation STI.

Selon un exemple, la gravure humide isotrope est à base d'une solution d'acide fluorhydrique dilué (dHF).

Il est précisé que dans le cadre de la présente invention, le terme « sur », « surmonte », « recouvre » ou « sous-jacent » ou leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais cela signifie que la première couche recouvre au moins partiellement la deuxième couche en étant soit directement à son contact soit en étant séparée d'elle par au moins une autre couche ou au moins un autre élément.

Une couche peut par ailleurs être composée de plusieurs sous-couches d'un même matériau ou de matériaux différents.

On entend par un substrat, une couche, un dispositif, « à base » d'un matériau M, un substrat, une couche, un dispositif comprenant ce matériau M uniquement ou ce matériau M et éventuellement d'autres matériaux, par exemple des éléments d'alliage, des impuretés ou des éléments dopants. Ainsi, un espaceur à base de nitrure de silicium SiN peut par exemple comprendre du nitrure de silicium non stœchiométrique (SiN), ou du nitrure de silicium stœchiométrique (Si3N4), ou encore un oxy-nitrure de silicium (SiON).

**En** général, mais non limitativement, un espaceur forme une bague autour de la grille, avec un contour fermé ; on pourrait donc parler d'un espaceur unique autour de la grille; cependant, les représentations en coupe, et les directions privilégiées des grilles, font que l'on parle aussi de paires d'espaceurs. Cette dernière terminologie est adoptée dans cette demande, où l'on distingue en l'occurrence une paire de premiers espaceurs et une paire de deuxièmes espaceurs.

La présente invention permet notamment la fabrication d'au moins un transistor ou d'une pluralité de transistors sur un substrat. Ce substrat peut être massif ou « bulk » selon la terminologie anglo-saxonne, ou encore de type semi-conducteur sur isolant, par exemple un substrat silicium sur isolant SOI (acronyme de l'anglais « silicon on insulator) ou un substrat germanium sur isolant GeOI (acronyme de l'anglais « germanium on insulator »).

L'invention peut également être mise en œuvre plus largement pour différents dispositifs ou composants micro-électroniques.

Par composant, dispositif ou élément de dispositif microélectronique, on entend tout type d'élément réalisé avec les moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...).

Plusieurs modes de réalisation de l'invention mettant en œuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer. Par ailleurs, le terme « étape » s'entend de la réalisation d'une partie du procédé, et peut désigner un ensemble de sous-étapes.

La siliciuration comprend typiquement un ensemble d'étapes permettant de former des parties ou des portions à base de NiSi du dispositif. Cet ensemble d'étapes regroupées sous la dénomination « module NiSi » est illustré à la figure 8.

Un objectif de la siliciuration est de faire diffuser, puis de faire réagir, un métal, généralement du nickel, au sein de portions de semiconducteur, généralement à base de Si, à partir d'une source de métal, généralement un alliage NiPt déposé en surface desdites portions de semiconducteur. Tel qu'illustré à la figure 8, la siliciuration peut ainsi comprendre une ou plusieurs étapes de « préparation au dépôt » permettant de nettoyer les surfaces, une étape de « dépôt NiPt », un premier « recuit thermique 1 » permettant d'initier une diffusion du nickel, une éventuelle étape intermédiaire de « retrait partiel du NiPt » permettant d'enlever un excès de métal, un éventuel deuxième « recuit thermique 2 » permettant de poursuivre ou de finaliser une diffusion du nickel, un « retrait de partie résiduelle d'alliage NiPt » finalisant la siliciuration.

La siliciuration est effectuée au moins au niveau des portions supérieures des grilles des transistors. Elle est généralement également effectuée sur des portions supérieures de sources et drains, par exemple surélevés, de part et d'autre du transistor.

Les portions supérieures peuvent être progressivement enrichies en Ni au cours de la siliciuration pour devenir les portions « siliciurées ». Les portions siliciurées sont effectivement siliciurées, c'est-à-dire totalement formées, à la fin de la siliciuration. Les portions supérieures et/ou siliciurées ne présentent pas nécessairement une concentration constante de nickel sur toute leur hauteur. Par souci de concision et selon les cas, les portions supérieures peuvent également désigner les portions « en cours de siliciuration » ou « destinées à être siliciurées ». L'objet de ces portions supérieures est parfaitement clair pour l'homme du métier, en fonction de l'étape de siliciuration auquel elles sont associées.

La siliciuration peut se faire en plusieurs étapes à partir d'un dépôt de NiPt. L'alliage NiPt déposé initialement évolue au cours des étapes de siliciuration. Typiquement, la concentration en nickel de l'alliage NiPt initial varie au cours de la siliciuration. Par exemple, à l'issue d'un premier recuit thermique lors duquel le nickel diffuse, l'alliage NiPt initial est enrichi en Pt. L'alliage initial devient dès lors un alliage NiPt intermédiaire, enrichi en Pt, qui peut être retiré par un retrait intermédiaire. Après un deuxième recuit thermique visant à finaliser la diffusion et la réaction du nickel au sein des portions supérieures, une partie résiduelle de l'alliage NiPt subsiste. Cette partie résiduelle est retirée à la fin du module de siliciuration. On distinguera éventuellement l'alliage NiPt initial, l'alliage NiPt intermédiaire, et l'alliage NiPt final ou résiduel, qui présentent des concentrations en nickel différentes. La partie résiduelle est à base d'alliage NiPt final.

Le nickel est un élément relativement mobile qui peut diffuser rapidement en fonction du budget thermique auquel il est soumis. Il peut notamment diffuser à partir de résidus métalliques d'alliage NiPt ou NiSi à la base des grilles, et éventuellement percer et court-circuiter la jonction entre la source ou le drain, et le canal. Un tel phénomène est couramment appelé « NiSi piping » (ou canalisation NiSi). Les résidus métalliques peuvent provenir d'un redépôt suite à une étape de gravure ou de nettoyage. Ces résidus métalliques sont indésirables. Il est préférable, voire nécessaire, de les éliminer pour éviter un risque de « NiSi piping » (dernière étape du « module SPT classique » d'un procédé standard connu illustré à la figure 8).

Un autre avantage du procédé selon l'invention est de limiter ou supprimer ce phénomène de « NiSi piping ». Les différents modes de réalisation du procédé selon l'invention permettent :
- soit d'éviter que des résidus métalliques soient générés lors du retrait des deuxièmes espaceurs (cas où le retrait des deuxièmes espaceurs est effectué avant dépôt de l'alliage NiPt),
- soit de protéger les portions en cours de siliciuration en conservant un alliage riche Ni en surface desdites portions (cas où le retrait des deuxièmes espaceurs est effectué avant le deuxième recuit thermique),
- soit de retirer les résidus métalliques en même temps que la siliciuration des portions supérieures est finalisée (cas où le retrait des deuxièmes espaceurs est effectué avant le retrait du platine).

Le procédé selon l'invention permet également de préserver les portions supérieures et/ou siliciurées et d'éviter leur endommagement.

On entend par dépôt NiPt « aux sommets des grilles » un dépôt de NiPt au moins aux sommets des grilles. Cela ne signifie pas que le dépôt NiPt se fait uniquement aux sommets des grilles. Généralement, le dépôt NiPt est effectué pleine plaque, c'est-à-dire de façon non sélective sur l'ensemble des structures présentes sur la plaque. Le dépôt NiPt se fait donc également par exemple sur les sources et drains des transistors. A titre d'exemple dans le cadre de la présente invention, la siliciuration subséquente à ce dépôt NiPt est principalement décrite pour les grilles, en particulier au niveau des sommets des grilles, d'où l'expression.

Les termes « motif de grille », «empilement de grille », « grille » sont employés en synonymes.

Dans la présente demande de brevet, on parlera préférentiellement d'épaisseur pour une couche, de hauteur pour un dispositif (transistor ou grille par exemple) et de profondeur pour une cavité ou une gravure. L'épaisseur est prise selon une direction normale au plan d'extension principal de la couche, la hauteur et la profondeur sont prises selon une direction normale au plan de base du substrat.

Les solutions de gravure sèche, c'est-à-dire par plasma, à base d'espèces fluorocarbonnées convenant au retrait des deuxièmes espaceurs sont généralement connues de l'homme du métier. Un plasma CH3F/O2 peut typiquement permettre de retirer des deuxièmes espaceurs à base de nitrure de silicium avec une bonne vitesse de gravure et une bonne sélectivité vis-à-vis de l'oxyde de silicium.

Les solutions de gravure humide convenant au retrait des deuxièmes espaceurs sont connues de l'homme du métier. Ainsi, un acide fluorhydrique dilué correspond typiquement à une dilution inférieure à 30% en volume, de préférence inférieure à 20 % en volume, et de préférence comprise entre 1% et 5% en volume. Un acide phosphorique chaud présente typiquement une température comprise entre 100°C et 150°C.

Les termes « sensiblement », « environ », « de l'ordre de » signifient « à 10% près » ou, lorsqu'il s'agit d'une orientation angulaire, « à 10° près ». Ainsi, une direction sensiblement normale à un plan signifie une direction présentant un angle de 90±10° par rapport au plan.

Le procédé de fabrication de transistors va maintenant être décrit en détail au travers de plusieurs modes de réalisation.

Dans tous les modes de réalisation du procédé de fabrication selon l'invention, le retrait des deuxièmes espaceurs se fait par gravure isotrope, sèche ou humide. Pour des deuxièmes espaceurs à base de nitrure de silicium (SiN), quatre solutions ou chimies de gravure, entre-autres possibles, ci-après référencées CHIM 1, CHIM 2, CHIM 3 et CHIM 4, peuvent être utilisées.

La solution de gravure CHIM 1 correspond à une gravure plasma isotrope à base d'espèces fluorocarbonnées, typiquement un mélange CH3F/O2. Une telle solution présente à la fois une bonne vitesse de gravure du SiN et une bonne sélectivité vis-à-vis du SiO2.

La solution de gravure CHIM 2 correspond à une gravure plasma isotrope à partir d'un plasma délocalisé suivi d'un recuit de sublimation, typiquement par un procédé de type SiCoNi^{™}. Le plasma délocalisé peut être à base d'un mélange NF3/NH3. Le rapport des concentrations NF3/NH3 peut être choisi entre 0,05 et 0,3, par exemple 0,07 ou 0,12 ou 0,2 ou de préférence 0,175 ou 0,25. Ces deux derniers rapports de concentration présentent un bon compromis entre vitesse de gravure (en Â/min) et sélectivité vis-à-vis du SiO2 (SiN/SiO2), tel qu'illustré dans le tableau suivant :

| Rapport de concentrations NF3/NH3 | Vitesse de gravure SiN (en Å/min) | Vitesse de gravure SiO2 (en Å/min) | Sélectivité SiN/SiO2 |
|---|---|---|---|
| 0,2 | 207 | 17 | 12,1 |
| 0,12 | 133 | 10 | 13,3 |
| 0,07 | 90 | 7 | 12,85 |
| 0,175 | 154 | 18 | 8,5 |
| 0,25 | 182 | 21 | 8,6 |

D'autres avantages de cette solution de gravure CHIM 2 sont décrits dans la suite. La solution de gravure CHIM 3 correspond à une gravure humide isotrope à base d'une solution d'acide fluorhydrique dilué (dHF) et d'acide phosphorique (H3PO4) chaud. Une telle solution présente à la fois une bonne vitesse de gravure du SiN et une bonne sélectivité vis-à-vis du SiO2.

La solution de gravure CHIM 4 correspond à une gravure humide isotrope à base d'une solution d'acide fluorhydrique dilué (dHF) seule. Certains avantages de cette solution de gravure CHIM 4 sont décrits dans la suite.

Dans tous les modes de réalisation du procédé de fabrication selon l'invention, le retrait des deuxièmes espaceurs se fait pendant le module NiSi dédié à la siliciuration, avant la fin dudit module NiSi, qui correspond au retrait de la partie résiduelle. Les premier et deuxième modes de réalisation prévoient le retrait des deuxièmes espaceurs avant le dépôt de métal NiPt. Cela permet avantageusement d'éviter toute interaction ultérieure avec le métal NiPt. Cela évite en particulier de pulvériser partiellement les parties métallisées à base de NiPt et/ou de NiSi. Cela évite la formation ultérieure de résidus métalliques. Les troisième et quatrième modes de réalisation prévoient le retrait des deuxièmes espaceurs avant le retrait de la partie résiduelle. Cela permet avantageusement de bénéficier de l'étape de retrait de la partie résiduelle pour retirer ou nettoyer les résidus métalliques.

Dans tous les cas, une étape ultérieure de nettoyage des résidus métalliques n'est plus nécessaire. Cela permet de réduire le nombre d'étapes total du procédé de fabrication. La suppression de l'étape de nettoyage des résidus métalliques, souvent agressive vis-à-vis de l'oxyde de silicium, permet en outre de préserver les tranchées d'isolation STI. La consommation d'oxyde de silicium des STI post-siliciuration est ainsi réduite. Le facteur de forme hauteur/largeur des espaces à remplir entre deux grilles adjacentes est diminué. Cela favorise un remplissage ultérieur des espaces sans formation de voids.

Le premier mode de réalisation est illustré aux figures 9A à 9C. La figure 9A illustre en coupe deux grilles adjacentes flanquées des premiers espaceurs 11a et des deuxièmes espaceurs 11b, avant siliciuration des portions supérieures 121. La figure 9B illustre le positionnement de l'étape de retrait des deuxièmes espaceurs 11b, également dénommée SPT (acronyme anglais de « Spacer Proximity Technology »), dans l'enchaînement d'étapes du module NiSi. La figure 9C illustre en coupe deux grilles adjacentes flanquées des premiers espaceurs 11a et comprenant des portions siliciurées 12, telles qu'obtenues à l'issue du module NiSi modifié par l'étape SPT.

Selon ce premier mode de réalisation, le retrait des deuxièmes espaceurs 11b est effectué en tout début du module NiSi, avant l'étape de « préparation au dépôt ». Une telle étape de « préparation au dépôt » vise généralement à retirer l'oxyde natif et/ou les impuretés, par exemple de type organique ou métallique, au sommet des grilles et/ou des sources et drains. Elle peut comprendre au moins un nettoyage préparatoire. Par exemple, un premier nettoyage préparatoire par voie humide peut être effectué à l'aide d'une solution d'acide fluorhydrique dilué dHF. Un deuxième nettoyage par voie sèche, par exemple par plasma Ar ou He peut être réalisé directement dans la machine de dépôt juste avant le dépôt métallique. Le nettoyage préparatoire peut donc comprendre l'un ou l'autre des nettoyages par voie sèche et humide, ou les deux.

La réalisation du SPT peut se faire avec les différentes chimies de gravure CHIM 1, CHIM 2, CHIM 3 et CHIM 4. De façon préférée, l'utilisation de la chimie de gravure CHIM4 (dHF) permet de remplacer et supprimer l'étape de « préparation au dépôt ». Cela permet de réduire encore le nombre d'étapes total du procédé de fabrication.

Le deuxième mode de réalisation est illustré aux figures 10A à 10C. La figure 10A illustre en coupe deux grilles adjacentes flanquées des premiers espaceurs 11a et des deuxièmes espaceurs 11b, avant siliciuration des portions supérieures 121. La figure 10B illustre le positionnement de l'étape SPT dans l'enchaînement d'étapes du module NiSi. La figure 10C illustre en coupe deux grilles adjacentes flanquées des premiers espaceurs 11a et comprenant des portions siliciurées 12, telles qu'obtenues à l'issue du module NiSi modifié par l'étape SPT.

Selon ce deuxième mode de réalisation, le retrait des deuxièmes espaceurs 11b est effectué immédiatement après l'étape de « préparation au dépôt », avant l'étape de dépôt NiPt. Le dépôt NiPt peut typiquement comprendre, préalablement au dépôt proprement dit, une gravure douce préalable visant à retirer les éventuels contaminants restant et s'assurer qu'il n'y pas d'oxyde interfacial avant le dépôt. Cette gravure douce préalable peut être faite à l'aide d'un procédé de type SiCoNi^{™}.

La réalisation du SPT peut se faire avec les différentes chimies de gravure CHIM 1, CHIM 2, CHIM 3 et CHIM 4. De façon préférée, l'utilisation de la chimie de gravure CHIM2 (SiCoNi^{®}) permet de remplacer et supprimer l'étape de gravure douce du dépôt NiPt. Cela permet de réduire encore le nombre d'étapes total du procédé de fabrication.

Le troisième mode de réalisation est illustré aux figures 11A à 11C. La figure 11A illustre en coupe deux grilles adjacentes flanquées des premiers espaceurs 11a et des deuxièmes espaceurs 11b, avant siliciuration des portions supérieures 121. La figure 11B illustre le positionnement de l'étape SPT dans l'enchaînement d'étapes du module NiSi. La figure 11C illustre en coupe deux grilles adjacentes flanquées des premiers espaceurs 11a et comprenant des portions siliciurées 12, telles qu'obtenues à l'issue du module NiSi modifié par l'étape SPT.

Selon ce troisième mode de réalisation, le retrait des deuxièmes espaceurs 11b est effectué avant l'étape de « recuit thermique 2 », de préférence immédiatement après l'étape de « retrait partiel du NiPt ». Le recuit thermique 2 peut être un recuit thermique rapide connu sous l'acronyme RTA (Rapid Thermal Annealing) ou un recuit laser. Le recuit thermique 2 permet notamment de finaliser la diffusion et la réaction du nickel dans les portions supérieures 121, de manière à obtenir les portions siliciurées 12.

La réalisation du SPT peut se faire avec les différentes chimies de gravure CHIM 1, CHIM 2, CHIM 3 et CHIM 4. L'utilisation des chimies de gravure humide CHIM3 (dHF + H3PO4) ou CHIM4 (dHF) permet de préserver les portions en cours de siliciuration à base de NiSi. Celles-ci présentent en effet, avant le recuit thermique 2, une phase riche en nickel à l'interface avec le dépôt métallique supérieur. Cette phase riche Ni est plus résistante que l'alliage NiSi vis-à-vis desdites chimies de gravure humide, et protège les portions à base de NiSi sous-jacentes. La phase riche Ni est en particulier moins sensible à l'endommagement, par lesdites chimies de gravure humide, que l'alliage NiSi, et peut être plus facilement restaurée par le recuit thermique 2. L'utilisation des chimies de gravure sèche CHIM 1 (CH3F/O2) ou CHIM2 (SiCoNi^{™}) est de préférence associée à un recuit thermique 2 par recuit laser. Cela permet d'éviter le phénomène de « NiSi piping ».

Le quatrième mode de réalisation est illustré aux figures 12A à 12C. La figure 12A illustre en coupe deux grilles adjacentes flanquées des premiers espaceurs 11a et des deuxièmes espaceurs 11b, avant siliciuration des portions supérieures 121. La figure 12B illustre le positionnement de l'étape SPT dans l'enchaînement d'étapes du module NiSi. La figure 12C illustre en coupe deux grilles adjacentes flanquées des premiers espaceurs 11a et comprenant des portions siliciurées 12, telles qu'obtenues à l'issue du module NiSi modifié par l'étape SPT.

Selon ce quatrième mode de réalisation, le retrait des deuxièmes espaceurs 11b est effectué avant l'étape de « retrait du Pt », de préférence immédiatement après l'étape de « recuit thermique 2 ». Le recuit thermique 2 peut être un recuit thermique rapide connu sous l'acronyme RTA (Rapid Thermal Annealing) ou un recuit laser.

La réalisation du SPT peut se faire avec les différentes chimies de gravure CHIM 1, CHIM 2, CHIM 3 et CHIM 4. L'utilisation des chimies de gravure humide CHIM3 (dHF + H3PO4) ou CHIM4 (dHF) permet de préserver les portions siliciurées à base de NiSi. Celles-ci sont en effet protégées par le dépôt métallique supérieur riche en Pt, avant retrait du Pt. Dans le cas d'une utilisation des chimies de gravure sèche CHIM 1 (CH3F/O2) ou CHIM2 (SiCoNi^{™}), un recuit laser supplémentaire à l'issue du module NiSi peut être effectué. Cela permet d'éviter le phénomène de « NiSi piping ».

De façon générale, l'invention n'est pas limitée aux modes de réalisation décrits mais s'étend à tout mode de réalisation entrant dans la portée de la revendication 1. L'invention permet avantageusement de réduire le nombre d'étapes total d'un procédé de fabrication de transistors, tout en favorisant un remplissage des espaces entre grilles adjacentes par ILD sans vides résiduels. Le phénomène de NiSi piping est également réduit voire éliminé par le procédé selon la présente invention.

## Revendications

1. Procédé de réalisation d'une pluralité de transistors sur un substrat comprenant au moins deux zones actives (20) adjacentes séparées par au moins une zone d'isolation électrique (30), chaque transistor de la pluralité de transistors comprenant une grille (10) présentant une portion siliciurée (12), et des premiers espaceurs (11a) de part et d'autre de la grille (10), les premiers espaceurs (11a) étant situés sur des flancs de la grille (10a), le procédé comprenant les étapes suivantes :
- une formation des grilles des transistors,
- une formation des premiers espaceurs (11a),
- une formation de deuxièmes espaceurs (11b) sur des flancs des premiers espaceurs (11a),
- une siliciuration des grilles configurée pour former les portions siliciurées (12) des grilles,
- un retrait des deuxièmes espaceurs (11b),
le procédé étant **caractérisé en ce que** le retrait (SPT) des deuxièmes espaceurs se fait pendant la siliciuration des grilles et avant que les portions siliciurées (12) soient totalement formées.

2. Procédé selon la revendication précédente, dans lequel la siliciuration des grilles comprend les sous-étapes suivantes :
- Un dépôt d'un alliage de nickel-platine NiPt aux sommets des grilles,
- Un premier recuit thermique de manière à diffuser et faire réagir une partie du Nickel Ni dudit alliage NiPt au niveau des portions supérieures (121) des grilles,
- Un retrait d'une partie résiduelle d'alliage NiPt n'ayant pas réagi, de manière à former les portions siliciurées (12),
et dans lequel le retrait (SPT) des deuxièmes espaceurs se fait avant le retrait de la partie résiduelle.

3. Procédé selon la revendication précédente, dans lequel le retrait (SPT) des deuxièmes espaceurs se fait avant le dépôt de l'alliage de nickel-platine NiPt aux sommets des grilles.

4. Procédé selon la revendication précédente comprenant en outre, avant le dépôt de l'alliage de nickel-platine NiPt aux sommets des grilles, les sous-étapes suivantes :
- Un recuit thermique préparatoire,
- Au moins un nettoyage préparatoire,
et dans lequel le retrait (SPT) des deuxièmes espaceurs se fait avant l'au moins un nettoyage préparatoire.

5. Procédé selon la revendication 3 comprenant en outre, avant le dépôt de l'alliage de nickel-platine NiPt aux sommets des grilles, les sous-étapes suivantes :
- Un recuit thermique préparatoire,
- Au moins un nettoyage préparatoire,
et dans lequel le retrait (SPT) des deuxièmes espaceurs se fait après l'au moins un nettoyage préparatoire.

6. Procédé selon la revendication 2 dans lequel le retrait des deuxièmes espaceurs se fait immédiatement avant le retrait de la partie résiduelle.

7. Procédé selon la revendication 2 comprenant en outre, après le premier recuit thermique, un retrait intermédiaire de l'alliage de nickel-platine NiPt enrichi en Platine Pt à l'issue du premier recuit thermique, et dans lequel le retrait (SPT) des deuxièmes espaceurs se fait après ledit retrait intermédiaire, et de préférence immédiatement après.

8. Procédé selon l'une quelconque des revendications précédentes dans lequel les deuxièmes espaceurs (11b) sont formés directement sur les flancs des premiers espaceurs (11a).

9. Procédé selon l'une quelconque des revendications précédentes dans lequel le retrait (SPT) des deuxièmes espaceurs se fait par une gravure plasma isotrope.

10. Procédé selon la revendication précédente dans lequel la gravure plasma isotrope est à base d'espèces fluorocarbonées.

11. Procédé selon la revendication 9 dans lequel la gravure plasma isotrope est effectuée à partir d'un plasma délocalisé suivi d'un recuit de sublimation.

12. Procédé selon l'une quelconque des revendications 1 à 8 dans lequel le retrait (SPT) des deuxièmes espaceurs se fait par une gravure humide isotrope.

13. Procédé selon la revendication précédente dans lequel la gravure humide isotrope est à base d'une solution d'acide fluorhydrique dilué (dHF) et d'acide phosphorique chaud.

14. Procédé selon la revendication 12 dans lequel la gravure humide isotrope est à base d'une solution d'acide fluorhydrique dilué (dHF).
